# EUROPEAN PATENT APPLICATION

(11) **EP 3 872 890 A1**
(43) Date of publication of application: **01.09.2021**
(21) Application number: 20172790.6
(22) Date of filing: 04.05.2020
(51) Int. Cl.: H01M 2/10, H01M 2/20, H01M 10/42, H01M 10/48, H05K 1/02, H05K 1/14

(54) **BATTERY ARCHITECTURE**

(30) Priority: 26.02.2020 GB 202002694
(71) Applicant: Cognition Energy Ltd, Littlemore, Oxford OX4 4LF (GB)
(72) Inventor: The designation of the inventor has not yet been filed
(74) Representative: Thorniley, Peter

(57) **Abstract**

There is provided a battery package and a circuit board which offer improved an improved architecture. In particular, the battery package may comprise a plurality of cells arranged in groups and at least one circuit board. Each circuit board comprises a substrate and a plurality of conductive regions provided on the substrate, wherein the cells of each group are independently coupled to the conducting regions such that cells within each group are coupled in parallel and the groups are coupled in series.

## Description

### Field

The present disclosure relates in general to improvements in battery packaging, and in particular, but not exclusively, to improvements in the components required for carrying current between a plurality of cells within the battery.

### Background

Efficient, low carbon, energy usage requires not only the ability to generate energy without environmental overheads, but the ability to store it effectively for use when needed. For example, electric vehicles can overcome the environmental concerns arising from the carbon and other emissions of vehicles which rely on internal combustion, but will only be widely adopted when competitive with existing technologies. This relies on reliable and efficient energy storage. Similarly, many sources of renewable energy provide a variable output, which may not be aligned the variation of demand on the electrical distribution grid. Efficient, robust and convenient energy storage solutions have a significant role to play in the technologies of the future.

The challenges for battery technology are particularly acute when situations demand high capacity, high voltage and/or high current. Generally, the voltage of a particular electrochemical cell is a function of the chemistry, and in order to increase the available voltage of the battery as a whole it is necessary to couple a plurality of cells in series. Similarly, in order to increase available capacity, it is common to couple a plurality of cells in parallel. As a result, in many applications, such as electric vehicles, large numbers (hundreds or even thousands) of cells are coupled. Typically, groups of parallel cells are coupled in series to obtain the necessary combination of voltage and capacity.

Accordingly, in any such battery formed of a plurality of cells suitable connections must be formed between the cells. This is often achieved through a bus bar. Each bus bar is coupled to the terminals of a given polarity for a group of cells, and may also be coupled to the terminals of the opposite polarity for a second group of cells. Thus the bus bar equalises potential across the terminals of each group, and may carry a (relatively small) balancing current to do so, while also acting as a conduit for the major charge or discharge current running through the groups in series. In general, bus bars are implemented as an integrated sheet of metal, such as aluminium or copper.

In addition to the functional need to couple cells together to form a coherent battery, in practical terms it is also beneficial and in some instances necessary to monitor the performance of the cells. For example, monitoring of the output voltage maybe indicative of a state of charge. While overall measurements may be carried out for the battery as a whole, important information about cell degradation and performance may be lost unless a more granular approach is taken. Accordingly, voltage measurement is typically implemented at a number of intermediate points (for example, measuring the potential at the terminals of some or all cells), thus providing information about the performance of (groups of) cells as well as the battery as a whole. This can allow appropriate charging/discharging control of the battery and accurate metrics to be provided to a user about likely battery performance.

However, voltage is not the only metric which can be relevant to battery performance. Environmental conditions can also play a significant role in performance, and in some cases can reflect current cell conditions. For example, temperature may both affect and be a function of cell performance. For this reason, it is often the case that as well as voltage sensors, batteries may be implemented with one or more temperature sensors. As is the case for voltage measurement, the provision of a greater number of temperature sensors may allow greater insight that will be provided into the performance of individual cells and/or groups of cells.

As the sophistication of battery management processes improves, so will the ability to take account of and reflect a wider range of sensor data. It may be desirable as a result to monitor other environmental conditions, such as humidity, or other aspects of operational behaviour.

As a result of the above, there is a tendency for battery packs to become increasingly complex in order to implement busbars together with the necessary wiring for an array of sensors. As well as increasing the overall weight and size of the pack - which can be particularly problematic in transport applications - this can lead to an increase in the potential number of failure points and a challenge in ensuring reliability in the manufacturing/construction process.

### Summary

According to a first aspect of the present disclosure, there is provided a battery package comprising: a plurality of cells arranged in groups; and at least one circuit board. Each circuit board comprises: a substrate; and a plurality of conductive regions provided on the substrate. The cells of each group are independently coupled to the conducting regions such that cells within each group are coupled in parallel and the groups are coupled in series.

The present disclosure also provides a circuit board for use with a battery comprising a plurality of cells arranged in two or more groups, the circuit boarding comprising: a substrate; and one or more conductive regions provided on the substrate, wherein at least one of the conductive regions is arranged to be coupled between groups of cells such that cells within each group are independently coupled to the conductive region in parallel and the groups are coupled in series.

In this manner, an integrated approach may be taken to coupling multiple cells within a battery package. In particular, the use of a circuit board in this manner may provide a robust and compact construction. Furthermore, in preferred embodiments, there are provided a plurality of conductive regions. For example, there may be three or more groups of cells and conductive regions provided between each pair of groups coupled in series. In this manner, the overall part count for the construction is reduced in comparison with the provision of multiple separate bus bars to couple groups of cells.

In preferred embodiments, the or each circuit board is a printed circuit board. Printed circuit board techniques are well understood in the art and provide reliable and compact solutions for the provision of conductive paths. The conductive regions are in general regions of conductive material, and may, for example, be conductive paths printed on to the circuit board (for example, in copper). In other examples, alternative elements may be provided as conductive regions provided or mounted on the circuit board. Each conductive region may comprise a single, integral conductive element or maybe provided as a conductive element comprises multiple parts.

Preferably, the circuit board further comprises one or more sensor tracks configured to provide sensor output. Integrating sensor tracks on to the same circuit board as the conductive regions coupling the cell groups further reduces part count. This will simplify assembly of battery packages, as well as assisting in providing increased reliability and a compact construction. Beneficially, this approach recognising that a circuit board (such as a printed circuit board) may carry both the major current for the battery (e.g. charge/discharge current) and the typically smaller currents used for sensing and/or manipulating conditions within a battery package.

For example, in some preferred embodiments, one or more sensor tracks are coupled to a respective conductive region in order to allow voltage measurement. In this manner, the potential difference across each group of cells can be identified from appropriate voltage measurements. Such information can be used to infer cell conditions, such as state of charge. Typically, a battery management system (which may be external to the circuit board or may be mounted thereon) may receive signals from the sensor tracks in order to monitor battery conditions. In some embodiments, the battery management system may also selectively discharge/charge groups of cells by applying current to one or more sensor tracks or through another appropriate mechanism.

In preferred embodiments, the or each circuit board further comprises one or more sensors, each coupled to one or more of the sensor tracks. The sensor may be mounted to the substrate. Again, this integration may provide a compact and robust design. A selection of the sensor tracks may be used for voltage measurement, while others may be coupled to the sensors. The sensors may comprise temperature sensors, optionally thermistors. Alternatively or additionally, other sensors may be provided.

In some preferred embodiments, the sensor tracks and conductive regions are coplanar. For example, they may be provided on a first face of the circuit board. This may be an exterior face, or where the board is a multi-layer board, an interior face of the board. Optionally, the sensors comprise sensors mounted on a second face of the circuit board opposite to the first face.

Preferably, the substrate comprises a plurality of openings, each opening configured to provide access to at least one terminal of at least one cell, wherein sets of openings are provided for cells of respective groups to allow coupling to the one or more conductive regions. In this manner, the conductive regions may be orientated on a face of the circuit board disposed away from the cells when in use, allowing improved access to these regions to facilitate their coupling to the cells. The openings allow access to cell terminals at the same time. As such, this arrangement provides a geometry which is both compact and relatively easy to assemble with other components to form a complete battery package.

In preferred embodiments, the circuit board further comprises: a first electrical terminal; and a conductive path arranged to electrically couple the first electrical terminal to a final conductive region of the one or more conductive regions, the conductive path being provided on a parallel plane to the conductive regions. In some embodiments, where the conductive regions are provided on a first (exterior) face of the circuit board, the conductive path is provided on a second, opposite, face. This allows an integrated and compact design, which facilitates a conductive path towards any desired region of the circuit board without requiring an increase in overall dimensions. Conductive elements on each plane/face can be connected by one or more vias, for example. In preferred embodiments, the circuit board further comprises a second terminal coupled to a first conductive region of the one or more conductive regions. Due to the conductive path, the first and second terminals may be located in any relative positions desired. For example, the first and second terminals may be co-located on the same side of the circuit board if so desired. It is also recognised that multiple terminals may be provided for each end of the electrical path formed by the electrical components of the circuit board if so required.

In some embodiments, the circuit board is formed as a multi-layer circuit board. This may allow additional current paths (including sensor tracks and/or conductive regions) without increasing the surface area of the board. Such a construction therefore provides excellent flexibility.

In preferred embodiments, the cells are coupled to the conducting regions by wire bonds.

### Brief Description of the Figures

Preferred embodiments of the present disclosure will now be described with reference to the accompanying figures in which:
Figure 1 illustrates a perspective view of battery arrangement of a first embodiment:
Figure 2 illustrates a first face of the circuit board of Figure 1;
Figure 3 illustrates a close up view of the first face;
Figure 4 illustrates a second face of the circuit board of Figure 1;
Figure 5 illustrates a perspective view of a battery package according to a second embodiment;
Figure 6 illustrates a perspective view of a battery package according to a third embodiment;
Figure 7 illustrates a perspective view of a battery package according to a fourth embodiment; and
Figure 8 illustrates a first face of a circuit board according to a fifth embodiment.

### Description

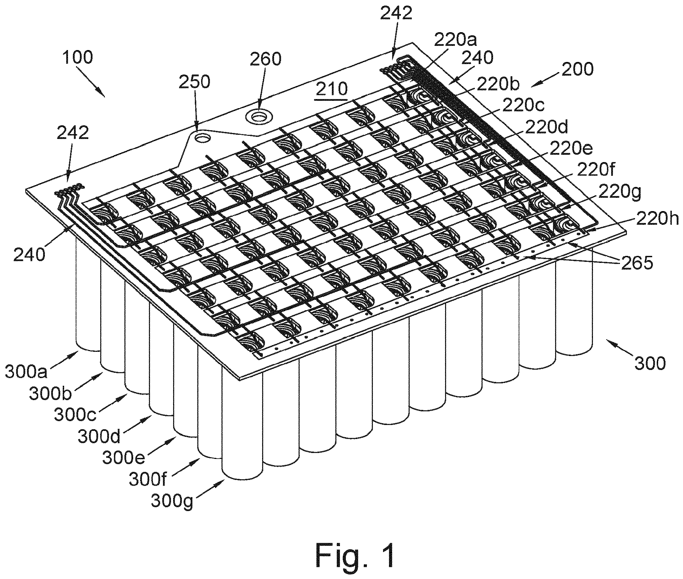

Referring to Figure 1, there is provided a battery package 100 comprising a circuit board 200 and a plurality of cells 300. The cells 300 are arranged in seven groups300a to 300g coupled in series. In this embodiment, the groups 300a to 300g are configured as rows 300a to 300g, but the skilled person will recognise that alternative geometries maybe implemented. The cells within a group are coupled in parallel, while the groups 300a to 300g are coupled to each other in series. In the illustrated example, each row comprises ten cells coupled in parallel. It will be appreciated that alternative implementations may comprise different numbers of rows and/or cells as appropriate.

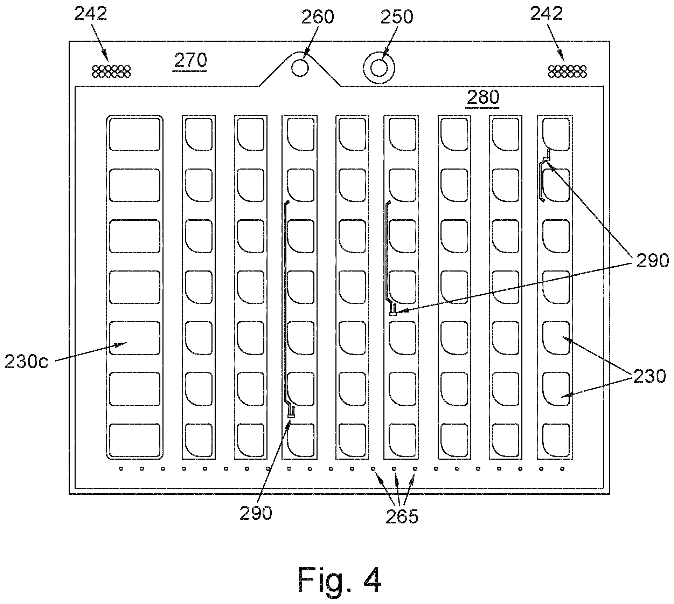

The circuit board 200 comprises a substrate having a top face 210 and a bottom face 270 (visible in Figure 4). The top face 210 is disposed opposite to the cells 300, while the bottom face 270 is adjacent to (i.e. facing) the cells 300. As will be detailed below, elements of the faces 210, 270 are in electrical contact with each other to provide a full conductive path. The circuit board 200 is implemented as a printed circuit board (PCB). In the illustrated example, the circuit board 200 has a thickness of around 2mm, which may comprise a thickness of around 1.5mm for the underlying substrate and additional thickness associated with conductive elements and any overlaying insulating layer. The circuit board 200 may be fixed relative to the cells using any appropriate technique, and for this purpose may be provided with one or more location holes (not shown). The top and bottom faces may be covered by an insulating layer covering the elements shown in Figures 1 to 4.

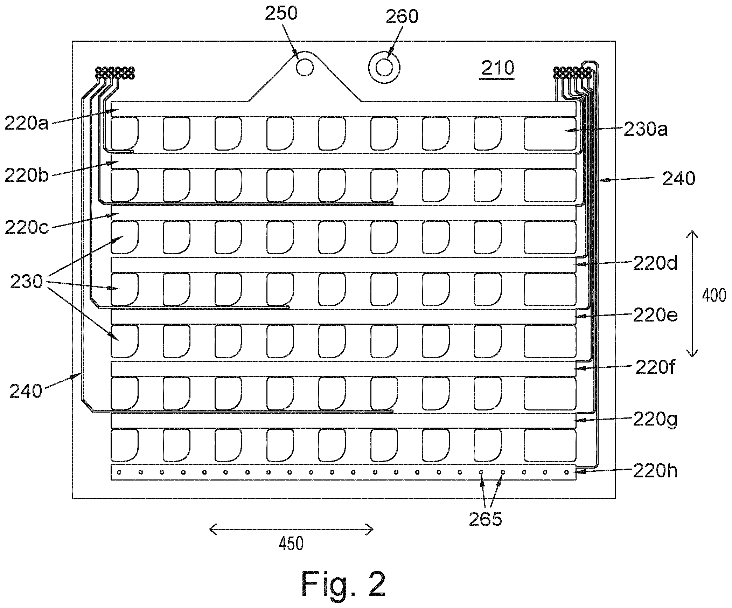

Visible in Figure 1 is the first, or top, face 210 of the circuit board 200. Details of top face 210 can be further seen in Figure 2. In particular, the top face 210 comprises a plurality of elongate conductive regions 220. The conductive regions 220 are formed of copper in this embodiment, but may be formed of any other conductive material, including but not limited to aluminium. The conductive regions 220 may be formed through conventional printed circuit board (PCB) techniques. In the preferred embodiment, each conductive region 220 has a thickness of around 70 micrometers, although it will be recognised that alternative thicknesses may be adopted. In general, the preferred thickness may depend upon the expected current load. In the example shown, the length (major axis) of each conductive region is around 180mm while the width is around 4mm (minor axis).

Figure 2 illustrates the general flow direction 400 of the major current through the battery pack (used as the charge/discharge current) and general flow direction 450 of the minor current within each conducting region 220.

The major current 400 is the current used to charge/discharge the battery pack 100; it maybe a relatively large current depending on the power output required or on the rate of charging. The geometry of the conductive regions 220 ensures adequate current path in this direction to carry such large currents without excessive power loss to resistance. The elongate nature of the conductive regions 220 ensures a relatively low resistance despite the relatively small thickness. In particular, a relatively large cross-sectional area is presented in the direction of current flow, while a minimal path length must be traversed by the current in each conductive region 220. In this manner, PCB technologies can be used to carry the large currents necessary for the battery pack, while at the same time integrating the relatively low current electronics necessary for diagnostic and sensing operations, as will be described below.

The minor current may arise from at least the following two sources: 1) a balancing current deliberately by a battery management system (BMS) to equalise the potential across each group of cells (or to otherwise control cell performance) and 2) a cell shunting current which will arise when cells within a group. In order to illustrate the concept of the balancing current, one may envisage a simplified scenario in which there are four groups of cells, G1 to G4. At a given moment in time, it may be observed that the voltage across the groups of cells is as follows:
G1: 3.7V
G2: 3.75V
G3: 3.7V
G4: 3.7V

The overall voltage of the battery pack in this scenario is the sum of the individual groups, i.e. 14.85V. The relative difference in voltage for group G2 in comparison with the other groups is indicative that group G2 is not fully synchronised (for example, group G2 may have a different state of charge to other groups). In order to rectify this imbalance, a battery management system (BMS) may be configured to apply a balancing current to discharge group G2 until the voltages of all groups match. Such a balancing current will normally be applied while the battery pack 100 is at rest (i.e. the main current 400 is zero). Moreover, the magnitude of the balancing current will be determined by the BMS (typically this will be less than 5A) and appropriate geometry for the conducting regions 220 chosen accordingly.

The cell balancing current may therefore address imbalances between groups of cells. The cell shunting current component of the minor current 450, in contrast, will respond to imbalances of cells within a given group. For example, different cells within a group may perform differently for a variety of reasons, including: different state of charge; different degradation levels; different temperatures; contact resistances in the pack or any other factor. Such variations in cell performance will cause currents to travel in the minor current 450 path until the potential across the conducting region 220 is equalised. Any significant currents arising in this manner (such as from unexpected cell failure) will be transitory, while ongoing currents will be very small.

In general, the dimensions of the board 200 illustrated in Figures 1 to 4 may be varied according to requirements. For example, where the cells 300 have a greater radius, or the required capacity of the cells is such that a greater number should be contained in each group, one may expect the major axis of the conductive regions 220 to be longer. Moreover, the minor axis of each conductive region, and/or its thickness, may be at least in part dependent upon an expected range of balancing currents between cells that may occur in use.

The circuit board 200 further comprises a plurality of openings, formed as cut-outs 230, through which the terminals of each cell 300 are accessible. As such, each intermediate conductive region 220b to 220g is disposed between two rows of cut-outs 230, while first and last conductive regions 220a, 220h are disposed adjacent to an end row of cut-outs 230. Terminals of each cell 300 may be coupled to an adjacent conductive region 220 through the cut-outs 230. In this embodiment, the terminals are wire bonded to the conductive regions 220, although the skilled person will recognise that other techniques may be applicable, such as laser welding. In some implementations, coatings may be provided for the wire connections to the conductive regions 220. In the preferred embodiment, the wires are formed of aluminium and an Electroless Nickel Immersion Gold (ENIG) layer is coated on the conductive region 220 (typically formed of copper) where the wire is connected The ENIG layer provides an electroless nickel plating covered with a thin layer of immersion gold for better interface with the aluminium wire.

The cut-out 230 geometry may be selected to take account of one or more of the following criteria: positive and negative terminal connections may be formed through each cut-out 230; sufficient clearance is given for the wire forming this connection to pass through the thickness of the circuit board 200; any damaged or failed cell may vent in order that gases may escape; and/or overall cut-out size is minimized (for example, to maximize space in the board 200 for current paths). In the embodiment shown, each row of cut-outs 230 comprises an end cut-out 230a which facilitates coupling between the last two cells 300 in a row. This allows an increased area of circuit board 200 adjacent to the end cut-outs 230a to be provided for sensor lines 240 discussed in more detail below.

Although the illustrated embodiments provide cut-outs 230, it will be recognised that openings 230 formed by any appropriate technique may be utilised for the purpose of facilitating connection between the cells 300 and the conducting regions 220.

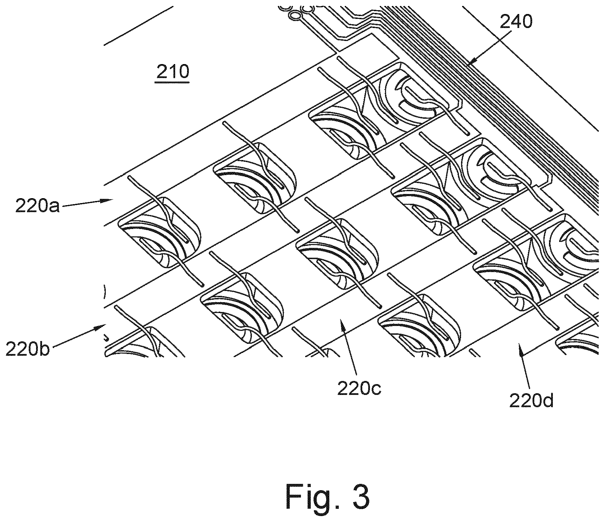

As illustrated, first conductive region 220a and last conductive region 220h are each coupled to a single row of cells 300. Remaining intermediate conductive regions 220b to 220g are each coupled to adjacent rows of cells 300. The intermediate conductive regions 220b to 220g are provided between the cut-outs 230 provided for the rows of cells to which they are coupled. Connections between a given row of cells 300 and the conductive regions 220 are formed along the major axis of the conductive regions 220. More particularly, for each row of the cells 300, terminals of a given polarity are connected to one conductive region 220 while terminals of the other polarity are connected to another adjacent conductive region 220. Accordingly, each row of cells 300 is connected in series. Figure 3 shows a closer view of the coupling if the cells to the conductive regions 220, illustrating the manner in which different terminals of each cell are coupled to adjacent regions.

The circuit board comprises a positive terminal 250 and a negative terminal 260 for connection to external components (such as those to be powered by the battery package 100). The positive terminal 250 is connected to the first conductive region 220a. Accordingly, the positive terminals of cell row 300a are coupled to the first conductive region 220a while the negative terminals of cell row 200a are coupled to the intermediate conductive region 220b. Similarly, the positive terminals of cell row 300b are coupled to the intermediate conductive region 220b while the negative terminals of cell row 300b are coupled to the intermediate conductive region 220c. This pattern continues until negative terminals of cell row 300g are coupled to last conductive region 220h. It will be recognised that the polarity of this arrangement could be reversed to provide a current flow in the opposite direction.

The top face 210 of circuit board 220 also comprises sensor tracks 240, as mentioned above. As illustrated each track 240 is coupled to a respective conductive region 220 in order to facilitate measurement of the potential thereof. The sensor tracks 240 run alongside the conductive regions 220 in order to reach the appropriate region and provide measurement terminals 242 at a distal end to the conductive regions 220. A connector (not shown) maybe provided coupled to the measurement terminals 242.

Additional sensor tracks 240 may be provided for coupling to further sensing elements. In particular, the circuit board may be provided with thermistors or other temperature sensing elements that can be read and/or powered via sensor tracks 240. Such elements may be disposed upon the bottom face 270 of circuit board 200 in order to ensure greater proximity to the cells. Where sensor tracks are provided in top layer 210 and sensors coupled to bottom face 270, one or more vias may be provided for electrical communication between top and bottom faces 210, 270. Temperature sensors 290 such as thermistors may be provided to monitor general battery conditions, or may be targeted to cell diagnostic or board diagnostic functions. An array of sensors 290, such as temperature sensors, may be provided in various locations in order to improve the measurement of average conditions within the battery pack 100 or to improve understanding of particular locations within the pack 100. Where an array of sensors is provided, multiple sensors may share sensor tracks 240 where appropriate; for example, a set of thermistors may share a common track 240 on one pad with an individually routed return track 240 for measurement purposes.

Multiple different sensor types may be provided where appropriate. These may include, but are not limited to: Hall-effect sensors (to measure current, particularly relatively high currents); shunt resistors (to measure current, particularly relatively low currents); cell balancing tracks; humidity sensors; accelerometers; or pressure sensors.

Additional components may also be integrated on to the circuit board 200. For example, fuses or other components serving electrical purposes may be integrated into or mounted onto the board 200.

In general, the sensor tracks 240 may be formed through conventional PCB techniques, and may have a width of, for example, 0.25mm. Measurement terminals 242 may be designed for connection to suitable external connectors. In particular, signals from sensor tracks may be passed to a battery management system (BMS) which may operate to control usage of the battery pack 100 in an optimised manner and/or to provide diagnostic information regarding the state of the battery pack 100. The BMS may also utilise the sensor tracks 240 to apply the cell balancing currents described above with relation to Figure 2. In the embodiment shown, the BMS is external to the circuit board 100, but it will be understood that it could be implemented as an integrated circuit (IC) chip mounted on the circuit board 200 itself.

The circuit board comprises vias 265 in final conductive region 220h. The vias provided an electrically conductive through connection between the top face 210 and bottom face 270. Bottom face 270 is illustrated in Figure 4. The bottom face 270 comprises return conductor 280 to carry current from the final conductive region 220h to negative terminal 260. In the embodiment shown, the return conductor 280 is implemented with two end regions and a number of discrete tracks extending between those end regions. In other embodiments, the return conductor may be a copper pour return on the PCB which thus covers the majority of bottom face 270 except for those areas covered occupied by cut-outs 230. This provides a wide conductive path to minimise resistance, although it will be recognised that other techniques may be adopted to provide the return conductor 280. Gaps may be provided in return conductor 280 to mount sensors such as thermistors. However, since sensor tracks 240 run on top face 210 they may be connected to such sensors through vias 265 in order to minimise interruptions in the return conductive path.

In the embodiment shown in Figures 1 to 4, both positive terminal 250 and negative terminal 260 are provided on one edge of the board 200. This is often convenient for connection with other components. However, the skilled person will appreciate that design of the board may be adjusted for provision of terminals 250, 260 on separate edges.

Similarly, in the embodiment described above, the circuit board 200 is provided with electrical elements on the two faces 210, 170. The skilled person will recognise that multilayer circuit boards may also be adopted to facilitate current paths in one or more internal layers, for example. Such implementations may, for example, facilitate a greater number of sensor tracks 240 or increase current carrying capacity.

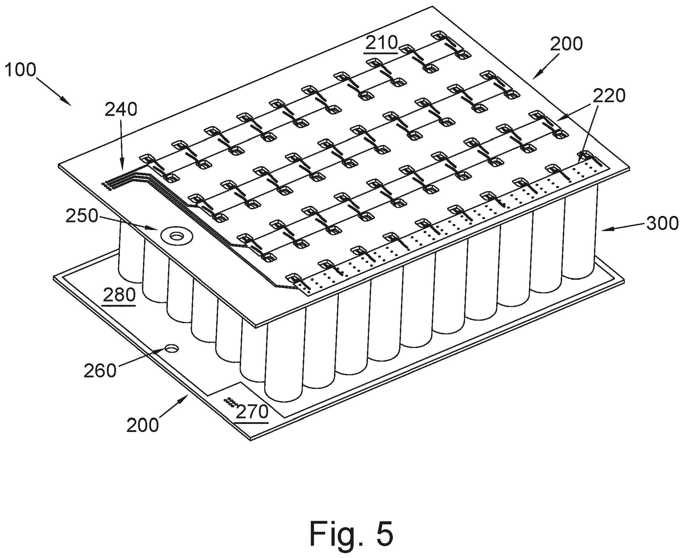

An alternative embodiment is shown in Figure 5. Like reference numerals are used for like features. In this embodiment, cells 300 are provided in alternating orientation by row, and further two circuit boards 200 are provided. That is to say, whereas in the embodiment illustrated in Figures 1 to 4, both positive and negative terminals of each cell were orientated towards the board 200 meaning that all connections to the cells were at a single end), in the embodiment of Figure 5, only one polarity is connected at each end of the cell. The alternating orientations are illustrated by "+" and "-" signs in Figure 5. In this manner, intermediate conductive regions 220 on each board are used to couple adjacent cell rows while only a single terminal 250, 260 is provided on each board. Each board has a first face 210 on which conductive regions 220 are provided and a second face 270 on which return conductor carries current to the available connector 250, 260. Sensor tracks 240 are provided on both boards 200 to allow measurement of voltage information for each conductive region 220. As in the embodiment of Figures 1 to 4, further sensors may be provided as appropriate.

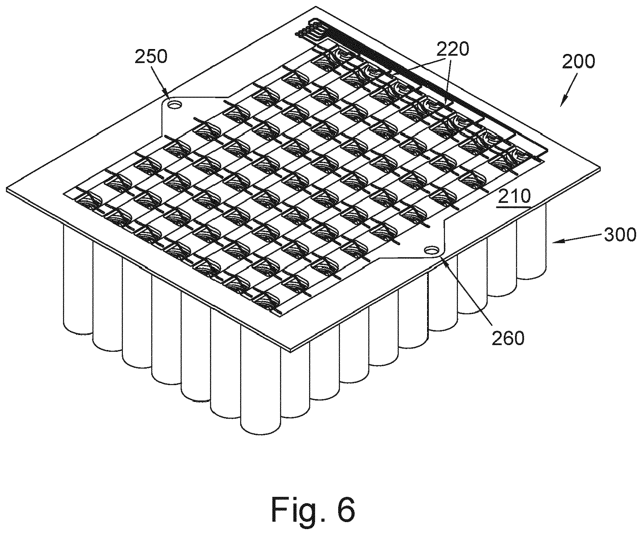

A still further embodiment is shown in Figure 6. In this embodiment, first conducting region 220a and last conduction region 220h are both coupled to a terminal 250, 260 on the top surface on opposite edges of the top face 210. Thus, the current path between terminals 250, 260 does not utilise the bottom face 270. As such, this embodiment may make use of only a single face of the circuit board 200, although the opposite face may be utilised if, for example, it is desired to mount one or more sensors on the bottom of the board 200. Similarly, a multilayer structure may be adopted for the board 200 if further layers of electrical structure are desired.

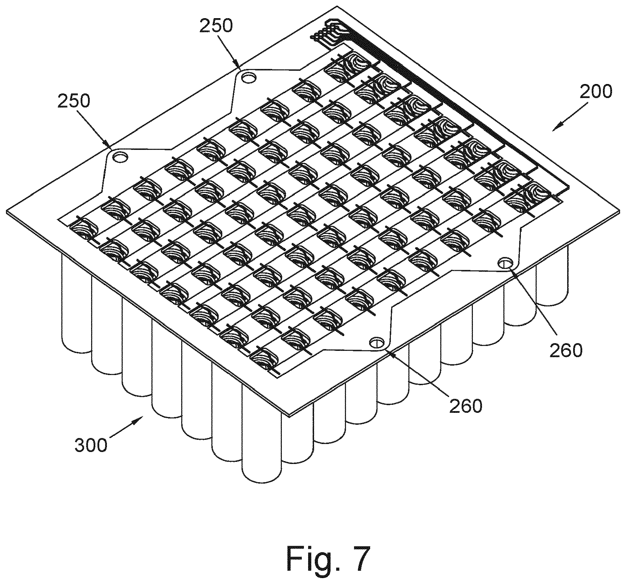

Variations and modifications of the above will be apparent to the skilled person without departing from the scope of the present disclosure. For example, while the embodiments above envisage a single positive terminal 250 and a single negative terminal 260, alternative implementations may include multiple terminals of each polarity. Such an approach is illustrated in Figure 7. Figure 7 shows a battery pack 100 implementing a board 200 of similar characteristics to that of Figure 6, save for the provision of two positive terminals 250 and two negative terminals 260. It will be recognised that further alternative arrangements may be adopted as appropriate.

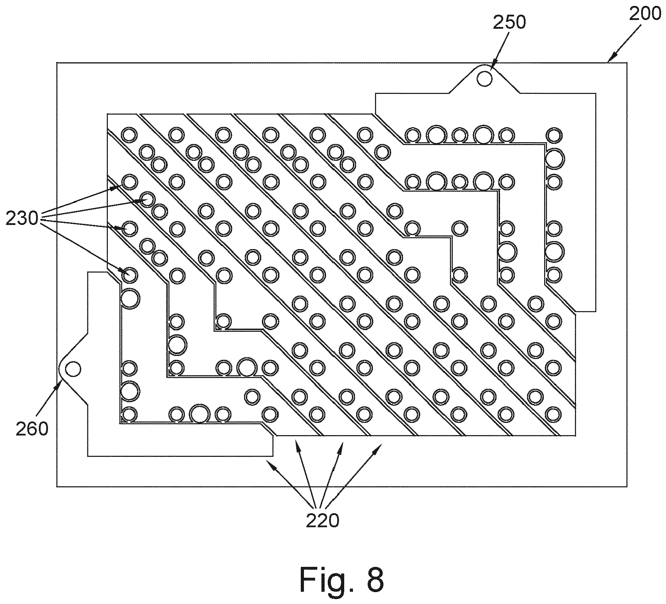

Moreover, the skilled person will consider changes in geometry and materials without departing from the underlying functionality of the described features, and will appreciate that alternative combinations of elements may be utilised. Figure 8 provides an example in which the terminals 250, 260 are provided in the corners of the board 200 while the openings 230 are provided within the conductive regions 220. Further variations and modifications of the approaches described above will also fall within the scope of the present disclosure.

## Claims

1. A battery package comprising,
a plurality of cells arranged in groups; and
at least one circuit board, each circuit board comprising:
a substrate; and
a plurality of conductive regions provided on the substrate,
wherein the cells of each group are independently coupled to the conducting regions such that cells within each group are coupled in parallel and the groups are coupled in series.

2. A battery package according to claim 1, wherein each circuit board is a printed circuit board.

3. A battery package according to any one of the preceding claims, wherein at least one circuit board further comprises one or more sensor tracks configured to provide sensor output.

4. A battery package according to claim 3, wherein at least one circuit board comprises one or more sensor tracks coupled to a respective conductive region in order to allow voltage measurement.

5. A battery package according to claim 3 or claim 4, further comprising one or more sensors, each coupled to one or more of the sensor tracks.

6. A battery package according to claim 5, wherein the sensor tracks and conductive regions are provided on a first face of the circuit board.

7. A battery package according to claim 6, wherein the sensors comprise sensors mounted on a second face of the circuit board opposite to the first face.

8. A battery package according to either claim 7 or claim 8, wherein the sensors comprise temperature sensors, optionally thermistors.

9. A battery package according to any one of the preceding claims, wherein the substrate comprises:
a plurality of openings, each opening configured to provide access to at least one terminal of at least one cell, wherein sets of openings are provided for cells of respective groups to allow coupling to the one or more conductive regions.

10. A battery package according to any one of the preceding claims, wherein each circuit board further comprises:
a first electrical terminal; and
a conductive path arranged to electrically couple the first electrical terminal to a final conductive region of the one or more conductive regions, the conductive path being provide on a parallel plane to the conductive regions.

11. A battery package according to claim 10, wherein each circuit board further comprises a second terminal coupled to a first conductive region of the one or more conductive regions.

12. A battery package according to any one of the preceding claims, wherein the circuit board is formed as a multi-layer circuit board.

13. A battery package according to any one of the preceding claims, wherein the cells are coupled to the conducting regions by wire bonds.

14. A circuit board for use with a battery comprising a plurality of cells arranged in two or more groups, the circuit boarding comprising:
a substrate;
one or more conductive regions provided on the substrate, wherein at least one of the conductive regions is arranged to be coupled between groups of cells such that cells within each group are independently coupled to the conductive region in parallel and the groups are coupled in series.

15. A battery package comprising a plurality of cells arranged in groups, and the circuit board of claim 14, wherein cells of adjacent groups are coupled to one another in series through one of the one or more conducting regions, with each cell within a group independently coupled in parallel to the conducting region.
